Europäisches Patentamt

European Patent Office

Office européen des brevets

(11) Veröffentlichungsnummer: **0 309 894**

**A2**

(12) **EUROPÄISCHE PATENTANMELDUNG**

(21) Anmeldenummer: 88115524.6

(22) Anmeldetag: 22.09.88

(51) Int. Cl.⁴: **H01L 23/04**

(30) Priorität: 28.09.87 DE 3732584
06.08.88 DE 3826820

(43) Veröffentlichungstag der Anmeldung:
05.04.89 Patentblatt 89/14

(84) Benannte Vertragsstaaten:
CH DE FR GB IT LI NL SE

(71) Anmelder: **Asea Brown Boveri
Aktiengesellschaft
Kallstadter Strasse 1
D-6800 Mannheim 31(DE)**

(72) Erfinder: **Klein, Erwin
Dresdner Strasse 5
D-6805 Heddesheim(DE)**

(74) Vertreter: **Rupprecht, Klaus, Dipl.-Ing. et al
c/o Asea Brown Boveri Aktiengesellschaft
Zentralbereich Patente Postfach 100351
D-6800 Mannheim 1(DE)**

(54) **Leistungshalbleiterelement.**

(57) Es sind Leistungshalbleiterelemente mit einem Gehäuse bekannt, bestehend aus einer elektrisch leitfähigen Bodenplatte, einer elektrisch leitfähigen Deckplatte und einem ringförmigen Isolator (24), wobei die elektrische Kontaktierung zwischen Bodenplatte, Halbleiterkristall und Deckplatte über Multifederkontakte (16) erfolgt. Das bekannte Halbleiterelement für größere Leistungen soll derart verbessert werden, daß unter Vermeidung von diffizilen Lötprozessen dieselben guten Eigenschaften wie bei gelöteten Multifederkontakten erreicht werden.

Die Multifederkontakte (16) sind gegen den Halbleiterkristall (15) verspannt und übernehmen sowohl die axiale wie die radiale Federung bei thermischen Lastwechselspielen.

Halbleiterelemente in Scheibenform für große Leistungen mit einem entsprechend großen Scheibendurchmesser.

EP 0 309 894 A2

## Leistungshalbleiterelement

Die Erfindung bezieht sich auf ein Leistungshalbleiterelement gemäß dem Oberbegriff des Anspruchs 1.

Bei Halbleiterelementen in Scheibenform für große Leistungen mit einem entsprechend großen Scheibendurchmesser wird die elektrische Verbindung durch Aneinanderpressen der einzelnen Elemente hergestellt. Diese als Druckkontaktierung bezeichnete Kontaktherstellung ist nicht Bestandteil der Halbleiterelemente, sondern sie wird im allgemeinen den erforderlichen Kühlelementen zugeordnet. Um die auch axial auftretenden thermischen Längenänderungen aufzunehmen, sind Federelemente erforderlich, so daß sich recht aufwendige Kontakteinrichtungen ergeben. Diese Druckkontaktierung, d.h. die Herstellung der elektrischen Verbindung durch Aneinanderpressen, ist zum Teil dadurch bedingt, daß die aneinandergepreßten Bauteile sehr unterschiedliche Ausdehnungskoeffizienten besitzen, so daß radiale und axiale Längendifferenzen bei Temperaturänderungen auftreten. Bei der Herstellung der Verbindung mittels Lötung ist aufgrund der Temperatureänderungen und der damit verbunden mechanischen Beanspruchungen ( = thermische Lastwechselspiele) eine dauerhafte elektrische Verbindung nicht sichergestellt.

Um die Dauerfestigkeit der Elemente zu erhöhen, die durch die thermischen Relativbewegungen den Anforderungen nicht entspricht, ist vorgeschlagen worden, z.B. in der DE-OS 29 37 049, mittels gelöteter Multifederkontakte die Nachteile der Druckkontaktierung zu umgehen. Unter einem Multifederkontakt ist ein Bauteil zu verstehen, das aus einer Vielzahl von federnden Einzelelementen besteht. Diese haben die Eigenschaft, in drei Ebenen zu federn. Deshalb treten auch nach Verlötung der Einzelelemente mit dem Halbleiterkristall keine mechanischen Spannungen mehr auf. Es stellt sich jedoch heraus, daß die hierfür erforderlichen Lötverbindungen zwischen Halbleiterscheibe und Multifederkontakten sehr diffizile Lötprozesse erforderlich machten, die das Bauteil verteuern.

Aufgabe der Erfindung ist es, ein Halbleiterelement für größere Leistungen derart zu verbessern, daß unter Vermeidung von diffizilen Lötprozessen dieselben guten Eigenschaften wie bei gelöteten Multifederkontakten erreicht werden.

Diese Aufgabe wird in Verbindung mit den Merkmalen des Oberbegriffes erfindungsgemäß durch die im Kennzeichen des Anspruchs 1 angegebenen Merkmale gelöst. Die mit der Erfindung erzielbaren Vorteile bestehen insbesondere darin, daß die Multifederkontakte des Leistungshalbleiterelements nicht nur zur Stromführung und Wärmeleitung dienen, sondern infolge der mechanischen Verspannung selbst die Kontaktkraft zur galvanischen und thermischen Kopplung herstellen.

Eine besonders vorteilhafte Ausführungsform ergibt sich dann, wenn sich eine Verspanneinrichtung (Ringschraube) am ringförmigen Isolator abstützt und die als Kontaktklötze ausgebildete Bodenplatte und Deckplatte gegeneinander preßt, wodurch die Multifederkontakte gegen den Halbleiterkristall mit vorgebbarer Druckkraft verspannt werden. Hierdurch wird die Anpreßkraft innerhalb des geschlossenen Halbleitergehäuses erzeugt, wobei die Verspannkraft von der Verspanneinrichtung (Ringschraube) über den oberen Kontaktklotz, den oberen Multifederkontakt, den Halbleiterkristall, den unteren Multifederkontakt, den unteren Kontaktblock und über den ringförmigen Isolator zur Verspanneinrichtung verläuft.

Es hat sich nun überraschend gezeigt, daß die Anwendung der erfinderischen Lösung, das Anpressen der Multifederkontakte an die Halbleiterscheibe, dieselben guten elektrischen und thermischen Kontaktierungen ergibt, wie beim Verlöten. Weiterhin hat sich gezeigt, daß wegen der Vielzahl von Kontaktstellen der Multifederkontakte nur die halbe Kontaktkraft erforderlich ist, wie bei der üblichen Druckkontaktierung. Wenn die Kontaktkraft des gewählten Halbleiterelementes bei etwa 20 kN liegt, muß man, da für den Multifederkontakt nur die halbe Kontaktkraft benötigt wird, die Kontaktkraft bei der Fertigung auf 11 kN bei 20°C einstellen. Bei minus 50°C wäre dann noch ein ausreichender Kontaktdruck vorhanden und bei 150°C würden dann 30 kN auftreten. Dies entspricht einem Wert der noch um 35 % kleiner ist als die bei der Druckkontaktierung einzustellende Kontaktkraft. In Wirklichkeit ist die Kraftdifferenz kleiner als 3 kN, da auch die Abspannglieder erwärmt werden und sich dehnen, wodurch sich an den Multifederkontakten kleinere Längenveränderungen einstellen.

Nach einem weiteren Merkmal der Erfindung soll der ringförmige Isolator einen L-förmigen Querschnitt aufweisen, wobei der kleinere Schenkel radial nach innen und der größere Schenkel axial gerichtet ist.

Desweiteren bsitzt jeder Kontaktblock in der Höhe verschiedene Durchmesser, wobei der Durchmesser der nach außen gerichteten Kontaktblockseite geringfügig kleiner ist als der von dem kleinen Schenkel des L-förmigen Isolator gebildete Innendurchmesser und wobei an der dem Inneren des Halbleiterelementes zugewandten Seite der Kontaktklötze ein Bund zur Lagerung auf einem Widerlager des L-förmigen Isolators bzw. der Verspanneinrichtung vorgesehen ist.

Nach weiteren Merkmalen der Erfindung ist es zweckmäßig, die Gasdichtheit des Inneren des Halbleiterelementes an den Auflagestellen zwischen den Kontaktklötzen und dem Isolator sowie der Verspanneinrichtung und am Gewinde zwischen ringförmigem Isolator und Verspanneinrichtung (Ringschraube) besonders zu sichern.

Nachstehend wird an einem Ausführungsbeispiel der erfinderische Gedanke erläutert.

Ein Halbleiterkristall 15, im gezeigten Beispiel ein Thyristor, wird durch untere und obere Multifederkontakte 16 beidseitig kontaktiert. Die Multifederkontakte 16 bestehen aus einer Vielzahl von Federelementen 8. Der untere Multifederkontakt ist mit einer zentrischen Bohrung 13 versehen, in welche eine axial federnde Büchse 12 eingesetzt ist. Zusammengehalten werden die Federelemente 8 durch eine äußere, ebenfalls axial federnde Büchse 7.

Mit den Multifederkontakten 16 stehen ein unterer Kontaktklotz 17 und ein oberer Kontaktklotz 32 in galvanischer Verbindung, die stoff- oder kraftschlüssig sein kann. Der untere Kontaktklotz 17 weist einen bund 18, eine Innenbohrung 11 und mindestens ein äußere Gewindebohrung 9 für den Anodenanschluß und für einen kraftschlüssigen thermischen Anschluß auf. Der obere Kontaktklotz 32 ist mit einem Bund 27 versehen. Außerdem ist mindestens in einem der Kontaktklötze - vorzugsweise im unteren Kontaktklotz 17 - ein Schlitz 14 vorhanden.

Über die zwei Bünde 18 und 27 werden der untere und obere Multifederkontakt 16 durch einen ringförmigen Isolator 24, z.B. aus Keramik, der mit nicht dargestellten Rippen zur äußeren Kriechwegverlängerung versehen sein kann, und eine Ringschraube 33 verspannt. Dazu besitzt der ringförmige Teil 2 des Isolators 24 in seinem unteren Teil einen sich nach innen erstreckenden Bund und oben ein Innengewinde 36. Der Querschnitt des ringförmigen Teiles 2 ist L-förmig, wobei der längere Schenkel axial gerichtet ist und der kürzere Schenkel im unteren Teil radial nach innen zeigt. In das Innengewinde 36 greift die Ringschraube 33 mit ihrem Außengewinde 35 ein. Der Bund 28 der Ringschraube 33 bildet das Widerlager zu dem Bund 27 des oberen Kontaktklotzes 32. Die Ringschraube 33 ist mit mindestens zwei nach außen gerichteten Bohrungen 34 versehen, in denen ein Schraubwerkzeug angesetzt werden kann.

Zur galvanischen Kontaktierung des Gates des Halbleiterkristalls 15 ist ein kleiner Druckkontakt 31 in Form einer Spiralfeder 30 vorhanden. Die Spiralfeder 30 ist mit einer elektrischen Leitung 23 verbunden. Elektrisch isoliert werden die Spiralfeder 30 durch ein in die Innenbohrung 11 des unteren Kontaktklotzes 17 eingelegtes Isoliertöpfchen 10 und die in den Schlitz 14 eingeführte elektrische Leitung 23 durch einen Isolierschlauch 19. Das Ende 22 der elektrischen Leitung 23 ist in ein Röhrchen 21 eingelötet. Das im Isolator 24 eingesteckte Röhrchen 21 ist Bestandteil einer nicht weiter dargestellten Pump- und elektrischen Steckereinrichtung 20 für den externen Gate-Anschluß. Nicht dargestellt ist der über den oberen Kontaktklotz 32 zu führende Kathodenanschluß.

Die Montage und Kontaktierung des Halbleiterelementes erfolgt wie nachstehend beschrieben:

Zunächst wird der untere Kontaktklotz 17 innerhalb des Isolators 24 eingebracht. Der Druckkontakt 31 wird in die vorgesehene Innenbohrung 11 eingelegt und das Leitungsende 22 der elektrischen Leitung 23 wird in das Röhrchen 21 eingeführt und mit diesem verlötet. Auf den unteren Kontaktklotz 17 wird dann der untere Multifederkontakt 16 gelegt, der eine Öffnung für den Druckkontakt 31 enthält und über diesen Druckkontakt 31 zentriert wird. Der untere Multifederkontakt 16 kann aber auch stoffschlüssig durch Löten mit dem unteren Kontaktklotz 17 verbunden sein. Dann muß die Leitung 23 in den Schlitz 14 eingefädelt werden.

Auf den unteren Multifederkontakt 16 wird danach der Halbleiterkristall 15 gelegt und durch einen nicht dargestellten Isolator, z.B. aus Kunststoff, zentriert. Anschließend werden der obere Multifederkontakt 16 und der obere Kontaktklotz 32 aufgelegt. Diese beiden Bauteile können durch stoffschlüssige Verbindung (Lötung) miteinander zentriert sein. Die Ringschraube 33 wird jetzt von Hand soweit eingedreht, bis ihr bund 28 auf dem Bund 27 des oberen Kontaktklotzes 32 aufliegt. Damit sind auch der oberе Kontaktklotz 32 und der zugehörige obere Multikontakt 16 zentriert.

Nach dieser nur unter geringer Kraft erfolgten Vormontange wird das Halbleiterelement 1 unter eine Presse mit Kraftanzeige gebracht. Die Auflage des Halbleiterelements erfolgt auf der Stirnseite 3 des Isolators 24 und die Druckkraft wird über die Stirnfläche 29 des oberen Kontaktklotzes 32 eingeleitet. Die Kontaktkraft wird langsam unter Nachziehen der Ringschraube solange erhöht, bis ihr Wert geringfügig höher als die Nominalkraft ist. Die Überschußkraft (= Differenzkraft zwischen eingestellter Kraft und einzustellender Nominalkraft) berücksichtigt das Setzen des Gewindespieles und etwaiger verformbarer Partien.

Um die elektrische Spannungsfestigkeit zwischen Anode und Kathode des Halbleiterkristalls 15 dauerhaft aufrechtzuerhalten, muß die "Atmosphäre" des Innenraumes 3 des Halbleiterelementes 1 rein und trocken sein und bleiben. Zwischen den Kontaktklötzen 17, 32 und dem Isolator 24, resp. der Ringschraube 33 und zwischen deren Gewinde 35 und dem Isolator 24 sollte daher ein gasdichter Abschluß erfolgen. Am besten geschieht dies an den Auflagen der Bünde 18, 27, 28, wofür mehrere Möglichkeiten bestehen. Es ist beispielsweise eine dauerelastische Dichtmasse 5 bzw. 26 verwendbar, welche auch die thermischen Relativbewegungen aufnimmt. Die Ringschraube 33 aus entsprechendem Stahl, beispielsweise, Invarstahl, wird vor dem Eindrehen am Gewinde 35, 36 mit einem Klebstoff 25 versehen, der zeitverzögert abbindet und so an dieser Steller dichtet.

Es sind auch andere Konstruktionen möglich, bei denen die Verspannung über den Isolator 24 erfolgt. Auch die Gasdichtheit kann, wie schon angedeutet, in anderer Weise hergestellt werden. Beispielsweise wäre eine Thermo-Kompressionsschweißung an den Bünden 18, 27, 28 unter Zwischenlage einer dünnen Aluminiumscheibe vorstellbar.

Die Multifederkontakte 16 können aus einer Vielzahl von Federbeinen bestehen, die entstehen, wenn bei einem vielfach pfeilförmig gestanzten Metallband nach dem spiraligen Wickeln die Verbindungsstege einseitig an der dem Halbleiterkristall zugewandten Seite entfernt werden. Alternativ hierzu können die Multifederkontakte 16 auch aus einer Vielzahl von Einzeldrähten bestehen, die in axialer Richtung verdrillt sind.

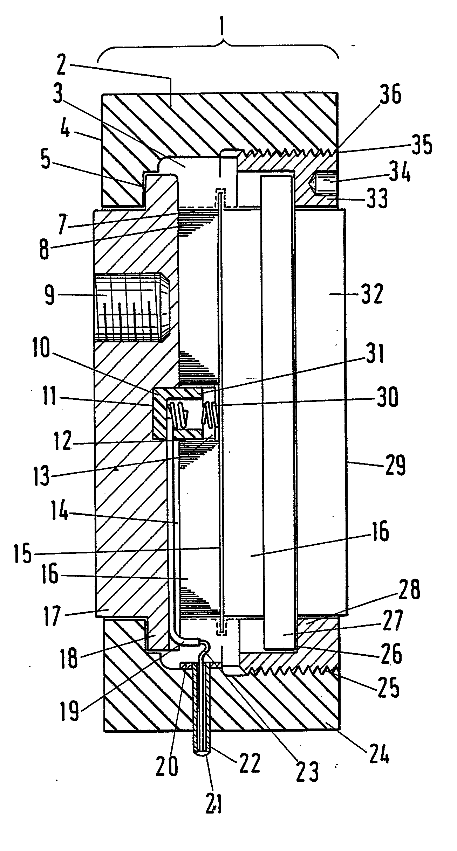

**Ansprüche**

1. Leistungshalbleiterelement mit einem Gehäuse, bestehend aus einer elektrisch leitfähigen Bodenplatte, einer elektrisch leitfähigen Deckplatte und einem ringförmigen Isolator, wobei die elektrische Kontaktierung zwischen Bodenplatte, Halbleiterkristall und Deckplatte jeweils über einen Multifederkontakt erfolgt, dadurch gekennzeichnet, daß die Multifederkontakte (16) gegen den Halbleiterkristall (15) mechanisch verspannt sind, wobei die Multifederkontakte sowohl die axiale wie die radiale Federung bei thermischen Lastwechselspielen übernehmen.

2. Leistungshalbleiterelement nach Anspruch 1, dadurch gekennzeichnet, daß eine sich am ringförmigen Isolator (24) abstützende Verspanneinrichtung die als Kontaktklötze (17, 32) ausgebildete Bodenplatte und Deckplatte gegeneinander preßt, wodurch die Multifederkontakte (16) gegen den Halbleiterkristall (15) mit vorgebbarer Druckkontakt verspannt werden.

3. Leistungshalbleiterelement nach Anspruch 2, dadurch gekennzeichnet, daß der ringförmige Isolator einen L-förmigen Querschnitt aufweist, wobei der kleinere Schenkel radial nach innen und der größere Schenkel axial gerichtet sind.

4. Leistungshalbleiterelement nach Anspruch 3, dadurch gekennzeichnet, daß jeder Kontaktklotz (17, 32) in der Höhe verschiedene Durchmesser besitzt, wobei der Durchmesser der nach außen gerichteten Kontaktblockseite geringfügig kleiner als der von dem kleineren Schenkel des L-förmigen Isolators (24) gebildete Innendurchmesser ist und daß an der dem Inneren des Halbleiterelementes zugewandten Seite der Kontaktklötze (17, 32) ein Bund (18, 27) zur Lagerung auf einem Widerlager des L-förmigen Isolators (24) bzw. der Verspanneinrichtung vorhanden ist.

5. Leistungshalbleiterelement nach einem oder mehreren der Ansprüche 1 bis 4, dadurch gekennzeichnet, daß die Verspanneinrichtung als eine in ein Gewinde des ringförmigen Isolators (24) eingreifende Ringschraube (33) ausgebildet ist.

6. Leistungshalbleiterelement nach einem der Ansprüche 1 bis 5, dadurch gekennzeichnet, daß an den Auflagestellen (18, 27, 28) zwischen den Kontaktklötzen (17) und dem Isolator (24) sowie der Verspanneinrichtung eine dauerelastische Dichtmasse (5, 26) eingebracht wird.

7. Leistungshalbleiterelement nach Anspruch 5, dadurch gekennzeichnet, daß in dem Gewinde (35, 36) zwischen Isolator (24) und Ringschraube (33) ein zeitverzögert abbindender Klebstoff eingebracht wird.

8. Leistungshalbleiterelement nach einem der Ansprüche 1 bis 7, dadurch gekennzeichnet, daß die Multifederkontakte (16) aus einer Vielzahl von jeweils abgewinkelten Federbeinen bestehen.

9. Leistungshalbleiterelement nach einem der Ansprüche 1 bis 7, dadurch gekennzeichnet, daß die Multifederkontakte (16) aus einer Vielzahl von Einzeldrähten bestehen, die in axialer Richtung verdrillt sind.